(19) Europäisches Patentamt
European Patent Office
Office européen des brevets

(11) **EP 3 326 281 B1**

(12) **EUROPÄISCHE PATENTSCHRIFT**

(45) Veröffentlichungstag und Bekanntmachung des Hinweises auf die Patenterteilung:
**14.09.2022 Patentblatt 2022/37**

(21) Anmeldenummer: **16729889.2**

(22) Anmeldetag: **15.06.2016**

(51) Internationale Patentklassifikation (IPC):
*H02M 3/155* *(2006.01)*  *H02M 1/14* *(2006.01)*
*H02M 1/32* *(2007.01)*

(52) Gemeinsame Patentklassifikation (CPC):
**H02M 1/14; H02M 1/32; H02M 3/155; H03F 3/2173; H02M 1/322**

(86) Internationale Anmeldenummer:
**PCT/EP2016/063687**

(87) Internationale Veröffentlichungsnummer:
**WO 2016/202826 (22.12.2016 Gazette 2016/51)**

(54) **SPANNUNGSQUELLE FÜR MODULIERTE GLEICHSPANNUNGEN**

VOLTAGE SOURCE FOR MODULATED DC VOLTAGES

SOURCE DE TENSION POUR DES TENSIONS CONTINUES MODULÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2015 DE 102015007696**

(43) Veröffentlichungstag der Anmeldung:
**30.05.2018 Patentblatt 2018/22**

(73) Patentinhaber: **iie GmbH & Co. KG**
**83564 Soyen (DE)**

(72) Erfinder: **KRESS, Ekkehard**
**83512 Wasserburg (DE)**

(74) Vertreter: **Oberhardt, Knut**
**Kanzlei Oberhardt**
**Unterratting 8**
**83123 AMERANG (DE)**

(56) Entgegenhaltungen:
**EP-A1- 0 621 679    WO-A1-02/073782**
**DE-A1- 2 652 275    JP-A- 2004 110 282**
**US-A- 5 747 942     US-A1- 2009 230 930**
**US-A1- 2014 285 258**

EP 3 326 281 B1

**Beschreibung**

Die Erfindung betrifft eine Spannungsquelle für modulierte Gleichspannungen nach dem Oberbegriff von Anspruch 1.

Solche Gleichspannungsquellen werden verwendet, um damit ein Führungssignal zu verstärken. Modulierte Gleichspannungsquellen zur Verstärkung eines Führungssignals mit breitem Frequenzband (etwa zwischen 1 und 100 kHz) werden meist mithilfe eines Verstärkers realisiert, wenn Leistungen zwischen wenigen kW bis in den mittleren zweistelligen Leistungsbereich benötigt werden. Der Verstärker wird dabei an eine Konstantspannungsquelle angeschlossen.

In der JP 2004 110282 A ist ein Schaltnetzteil gezeigt, welches eine konstante Ausgangsspannung liefern soll. Zu diesem Zweck ist eine Regelstufe vorgesehen, die die Ausgangsspannung des Schaltnetzteils und eine Referenzspannung verwendet. Die Regelung wirkt direkt auf den Treiber ein, über den zwei Verstärkerschalter angesteuert werden. In der US2014/0285258 A1 ist einen Verstärker für einen Lautsprecher gezeigt.

Standardmäßige Konstantspannungsquellen sind in der Regel mit großen Kondensatoren am Ausgang bestückt. So weist beispielsweise ein Schaltnetzteil für eine Ausgangsspannung von 50 V und eine Leistung von 3 kW nach dem Stand der Technik Ausgangskondensatoren im Gesamtwert von 5000 uF auf. Bei einer Spannungsmodulation einer derartigen Quelle wäre der kapazitive Blindstrom um ein Vielfaches größer als der Laststrom, so dass eine Modulation der Ausgangsspannung - sogar bei niedrigen Frequenzen - praktisch nicht möglich wäre.

Es wurde auch versucht mit auf Dynamik optimierten Schaltnetzteilen hocheffiziente Spannungsquellen zu schaffen. Bei solchen Schaltnetzteilen besitzt ein Glättungskreis aus Spule und Kondensator oft eine Resonanzfrequenz die - je nach Leistung und benutzter Technologie - nur ein Fünfzigstel bis zu einem Zweihundertstel der Schaltfrequenz beträgt. In der Praxis zeigte sich, dass - bedingt durch die aus der internen Verarbeitung resultierenden Latenzzeiten - es unter Einhaltung wirtschaftlicher Aspekte nicht möglich ist, geregelte Systeme mit guter Linearität ohne Eigenschwingungen über den gesamten erforderlichen Dynamik- und Lastbereich mit vertretbarem Aufwand zu realisieren.

Der schlechte Wirkungsgrad dieser Schaltnetzteile ist auch durch die verwendete Regelung bedingt. Bei der Regelung entstehen große Latenzzeiten, die zu Schwingungen führen. Dabei wird eine große Menge Energie nicht in Leistung umgesetzt, sondern in nicht benötigte Wärme umgewandelt. Diese Wärme muss wiederum abgeführt und vernichtet werden, was sich weiterhin negativ auf den Wirkungsgrad auswirkt.

Der Erfindung liegt die Aufgabe zugrunde, eine Spannungsquelle für modulierte Gleichspannungen so aufzubauen, dass eine hohe Kosteneffektivität und ein hoher Wirkungsgrad erreicht werden.

Gelöst wird die Aufgabe gemäß der Erfindung durch eine Spannungsquelle für modulierte Gleichspannungen mit den Merkmalen von Anspruch 1. Durch die Verwendung einer Spannungsregelung für die Gleichspannungsquelle, die die Ausgangsspannung der Gleichspannungsquelle konstant hält, eines ersten, parallel zu der statischen Gleichspannungsquelle geschalteten, durch eine ungeregelte Steuerung ein- oder ausschaltbaren, elektronischen Schaltelements, eines in Reihe zu dem ersten elektronischen Schaltelement und parallel zu der Gleichspannungsquelle geschalteten zweiten, durch die Steuerung ein- oder ausschaltbaren, elektronischen Schaltelements, einer in Reihe mit dem ersten elektronischen Schaltelement und parallel zu dem zweiten elektronischen Schaltelement geschalteten Spule, eines in Reihe mit der Spule geschalteten Glättungskondensators und einer parallel zu dem Glättungskondensator geschalteten Last, lässt sich mit einem sehr geringen ohmschen Widerstand und somit mit wenig Verlusten arbeiten.

Es soll hier betont werden, dass das erste und das zweite elektronische Schaltelement von der Steuerung nicht linear angesteuert werden. In Zusammenhang mit der Steuerung werden hier tatsächliche Schaltelemente realisiert, die sich nur im ein- oder im ausgeschalteten Zustand befinden können. Während des Betriebs der Vorrichtung befindet sich grundsätzlich nur eines der beiden elektronischen Schaltelement im eingeschalteten Zustand, während sich das jeweils andere im ausgeschalteten Zustand befindet.

Bei der Verwendung entsprechend moderner Bauteile reagiert die Schaltung fast wie ein ideales System. Dadurch ist kein geschlossener Regelkreis notwendig und es ist erstmals eine ungeregelte Steuerung ausreichend. Eine Regelung ist lediglich für die statische Gleichspannungsquelle vorgesehen, so dass davon ausgegangen werden kann, dass immer eine sehr exakte Gleichspannung zur Verfügung steht. Solche geregelten Gleichspannungsquellen sind heute üblich und bedeuten keinen großen Aufwand. Durch das Fehlen einer Regelung für die Modulation und durch das Fehlen der damit verbundenen Rückkopplung an die Steuerung werden Phasenverschiebungen und Verzerrungen minimiert, sowie weitere Verluste vermieden, so dass die Schaltung mit sehr hohem Wirkungsgrad arbeitet und daher auch sehr klein aufgebaut werden kann. Es kann folglich eine relativ einfache Steuerung verwendet werden, die keinen hohen Kosteneinsatz erfordert.

Die Erfindung lässt sich erfolgreich in einem benötigten Leistungsbereich zwischen 1 und 50 kW verwenden. Die modulierte Gleichspannung liegt vorteilhaft in einem Bereich von 1 bis 200 kHz. Die modulierte Gleichspannung kann folglich mit hoher aber auch mit sehr niedriger Frequenz moduliert worden sein. Sie kann sogar Abschnitte enthalten, die einen nichtmodulierten, statischen Spannungspegel ergeben. Die beiden elektronischen Schaltelemente werden insbesondere aber mit einer Schaltfrequenz zwischen 150 und 800 kHz betrieben. Diese Frequenz wird im Folgenden einfach als Schaltfrequenz bezeichnet.

Weitere Einzelheiten und Vorteile der Erfindung ergeben sich aus den Unteransprüchen.

Das erste und das zweite Schaltelement sollen in durchgeschaltetem Zustand einen möglichst geringen Widerstand aufweisen. Nur auf diese Weise kann ein fast ideales Verhalten der Schaltung mit sehr geringer Verlustleistung erreicht werden. Deshalb ist sowohl das erste elektronische Schaltelement als auch das zweite elektronisches Schaltelement jeweils als Feldeffekttransistor (FET) ausgebildet. Moderne FETs weisen diese Charakteristik mit einem Widerstand von nur wenigen Milliohm auf und sind deshalb bestens für diese Anwendung geeignet. Sollte für hohe Ströme der Widerstand der FETs für ein ideales Verhalten der Schaltung noch zu groß sein, können jeweils statt eines FETs auch mehrere dieser Bauteile parallel geschaltet werden.

Um ein moduliertes Gleichspannungssignal zu erhalten, werden die FETs aber nicht wie bei einer analogen Endstufe angesteuert, bei der sie im Linearbetrieb, ähnlich wie ein gesteuerter Widerstand betrieben werden. Das erste und das zweite elektronische Schaltelement sind im Gegensatz dazu gegenphasig vollständig ein- bzw. ausgeschaltet. Das bedeutet, dass zu jedem Zeitpunkt während des Betriebs der Schaltung eines der elektronischen Schaltelemente durchgeschaltet ist und zwischen den Anschlüssen praktisch keine Spannung abfällt, während das andere elektronische Schaltelement hochohmig gesperrt ist. Es gibt keine Zwischenzustände, so dass der Strom immer entweder durch das eine oder das andere elektronische Schaltelement fließt, nie aber durch beide gleichzeitig.

Die beiden elektronischen Schaltelemente werden über eine ungeregelte Steuerung geschaltet. Ist die ungeregelte Steuerung als digitale Steuerung aufgebaut, weist diese wenigstens einen Analog-Digital-Wandler auf. Dabei wird ein der Steuerung zugeführtes analoges Führungssignal in digitale Datenpakete konvertiert, die an einen digitalen Controller weitergegeben werden. Der digitale Controller generiert aus den digitalen Daten die Schaltsignale zur Ansteuerung der beiden elektronischen Schaltelemente.

Je nach der Qualität der Regelung der Gleichspannungsquelle, kann die Gleichspannung eine mehr oder weniger große Restwelligkeit aufweisen. Diese Restwelligkeit des Spannungssignals kann problemlos mit der digitalen Steuerung korrigiert werden. Die digitale Steuerung weist zu diesem Zweck besonders vorteilhaft einem weiteren Analog-Digital-Wandler auf, der mit der geregelten Gleichspannungsquelle und mit dem digitalen Controller verbunden ist. Auf diese Weise müssen an die Regelung der Gleichspannungsquelle keine hohen Ansprüche gestellt werden und es lässt sich trotzdem ein hervorragendes Ergebnis erzielen.

Die ungeregelte Steuerung kann aber auch als analoge Steuerung aufgebaut sein. In der analogen Steuerung, der ebenfalls das analoge Führungssignal zugeführt wird, ist ein Komparator vorgesehen. Weiterhin liegt an dem Komparator das Signal eines Sägezahngenerators an. Die Frequenz des Sägezahn-Signals entspricht der Schaltfrequenz der beiden elektronischen Schaltelemente. Die Steuersignale zur Ansteuerung der beiden elektronischen Schaltelemente werden über einen Vergleich der beiden anliegenden Signale generiert.

Sollte die Steuerung ausfallen oder die alternierende Schaltung der beiden elektronischen Schaltelemente aus einem anderen Grund plötzlich gestoppt werden und beide gleichzeitig hochohmig werden, beispielsweise durch eine Überstromschutzschaltung, können Spannungsspitzen auftreten, die zu einer Beschädigung oder sogar zu einer Zerstörung der Schaltung oder einzelner Bauteile davon führen können. Um dies zu verhindern, ist parallel zu dem ersten und dem zweiten elektronischen Schaltelement jeweils eine Freilaufdiode geschaltet. Über diese Freilaufdioden kann jeweils in der Schaltung gespeicherte Energie abgeführt werden. Die Freilaufdioden können aber entfallen, wenn bereits in den elektronischen Schaltelementen selbst entsprechende parasitäre Dioden verbaut sind.

Ein ähnliches Problem kann entstehen, wenn die Last, die an den Ausgangsklemmen der Schaltung anliegt, plötzlich abgeworfen wird. Für diesen Fall ist eine erste Spannungsbegrenzungsdiode in Reihe zu der Spule und parallel zu dem ersten elektronischen Schaltelement geschaltet oder die erste Spannungsbegrenzungsdiode und eine zweite Spannungsbegrenzungsdiode sind parallel zu dem zweiten elektronischen Schaltelement geschaltet. In dem oben beschriebenen Fall kann die in der Spule gespeicherte Energie über die Spannungsbegrenzungsdiode in die Gleichspannungsquelle rückgeführt werden. Auf diese Weise kann diese Energie zu keinen Überspannungsschäden führen, geht aber dem System auch nicht verloren.

Um ein moduliertes Gleichspannungssignal mit einem kleinen, über Kondensatoren mit geringer Kapazität glättbaren Ripple zu erhalten, sollte die Schaltfrequenz, mit der die beiden elektronischen Schaltelemente betrieben werden, eine bestimmte Mindestfrequenz nicht unterschreiten. Die ungeregelte Steuerung schaltet das erste und das zweite elektronische Schaltelement deshalb mit einer Frequenz größer 150 kHz, insbesondere aber größer 200 kHz.

Die minimale Schaltfrequenz ist unter anderem von der der maximalen Modulationsfrequenz der Gleichspannung abhängig. So kann die modulierte Gleichspannung eine Frequenz bis zu 200 kHz aufweisen, wenn die Schaltfrequenz entsprechend hoch angesetzt ist.

Um Oberwellen auf dem modulierten Gleichspannungssignal zu reduzieren, ist besonders vorteilhaft ein Saugkreis mit einer Resonanzspule und einem Resonanzkondensator vorgesehen, wobei der Saugkreis parallel zu dem Glättungskondensator angeordnet ist. Der Saugkreis ist auf die Schaltfrequenz der elektronischen Schaltelemente abgestimmt und sorgt so für eine Minimierung der kapazitiven Belastung des Systems, da auf diese Weise der Glättungskondensator sehr klein ausgeführt werden kann.

Um die erfindungsgemäße Schaltung mit geringen Phasenverschiebungen und Verzerrungen betreiben zu können, spielt die Abstimmung zwischen der Spule und dem Glättungskondensator eine erhebliche Rolle. Besonders vorteilhaft ist die Abstimmung, wenn die Spule und der Glättungskondensator auf eine Resonanzfrequenz abgestimmt sind, die zwischen einem Drittel und einem Fünfzehntel der Frequenz beträgt, mit der das erste und das zweite elektronische Schaltelement geschaltet werden. Bei einer verwendeten Schaltfrequenz von beispielsweise 300 kHz soll die Resonanzfrequenz von Spule und Glättungskondensator folglich zwischen 20 und 100 kHz betragen. Insbesondere soll sie aber zwischen einem Sechstel und einem Zwölftel der Schaltfrequenz, in obigem Beispiel also etwa zwischen 25 und 50 kHz betragen. Auf diese Weise kann gewährleistet werden, dass die Schaltung sehr resonanzarm und mit möglichst kleinen kapazitiven Blindströmen belastet ist und dadurch mit nur sehr geringen Verlusten arbeitet.

Besonders vorteilhaft ist als Last ein Hochfrequenzverstärker vorgesehen, der zusätzlich mit einem Hochfrequenzsignal aus einem Oszillator gespeist wird. Auf diese Weise erhält man ein amplitudenmoduliertes Hochfrequenzsignal, welches aus dem ursprüngliches Führungssignal erzeugt wurde. Das System reagiert sehr dynamische auf Frequenzänderungen des Führungssignals und arbeitet äußerst verlustarm mit hoher Kosteneffizienz.

Die Spannungsquelle ist als Schaltnetzteil mit einer Ausgangsleistung von mehr als ein Kilowatt ausgebildet. Insbesondere sind Schaltnetzteile mit einer Leistung zwischen ein und fünfzig Kilowatt auf diese Weise mit geringen Kosten und sehr verlustarm zu realisieren. In dem genannten Leistungsbereich kann bei Verwendung einer geregelten Gleichspannungsquelle ohne weiteres auf eine Regelung, die die elektronischen Schaltelemente aufwändig über eine Regelschleife ansteuert, verzichtet werden.

Weitere Einzelheiten und Vorteile der Erfindung ergeben sich aus der Beschreibung eines Ausführungsbeispiels, das anhand der Zeichnung eingehend erläutert wird.

Es zeigt:

Fig. 1 die Schaltung einer erfindungsgemäßen Spannungsquelle,

Fig. 2 die Steuerung der Spannungsquelle aus Fig. 1, als analoge Steuerung aufgebaut,

Fig. 3 die Steuerung der Spannungsquelle aus Fig. 1, als digitale Steuerung aufgebaut,

Fig. 4 die erfindungsgemäße Spannungsquelle aus Fig. 1 in Verbindung mit einem Hochfrequenz-Verstärker,

Fig. 5 ein durch den Modulator verstärktes und geglättetes Modulationssignal als Versorgungsspannung für den Hochfrequenzverstärker,

Fig. 6 das hochfrequente Sinussignal eines Hochfrequenzoszillators als Trägerfrequenz für den Hochfrequenzverstärker und

Fig. 7 das am Ausgang des Hochfrequenzverstärkers anliegende, durch das Modulationssignal modulierte Hochfrequenzsignal.

Mit dem Bezugszeichen 3 ist das Führungssignal bezeichnet. Dieses hochdynamisch modulierte Führungssignal soll leistungsverstärkt werden, aber in Form und Phase möglichst unverändert bleiben. Das Führungssignal 3 wird an die Steuerung 5 des Modulators 1 angelegt.

Die Stromversorgung 26 ist standardmäßig aufgebaut und besteht aus der mit großer Leistung belastbaren statischen Gleichspannungsquelle 2 und dem Kondensator 4. Der Kondensator 4 ist stellvertretend für mehrere Kapazitäten eingezeichnet, die bei auftretenden Spannungsspitzen diese aufnehmen können und die Gleichspannungsquelle 2 so vor einer Beschädigung schützen sollen. Bei der Gleichspannungsquelle handelt es sich um eine geregelte Gleichspannungsquelle, also um eine so genannte Konstantspannungsquelle, die eine sehr exakte Spannung zur Verfügung stellt.

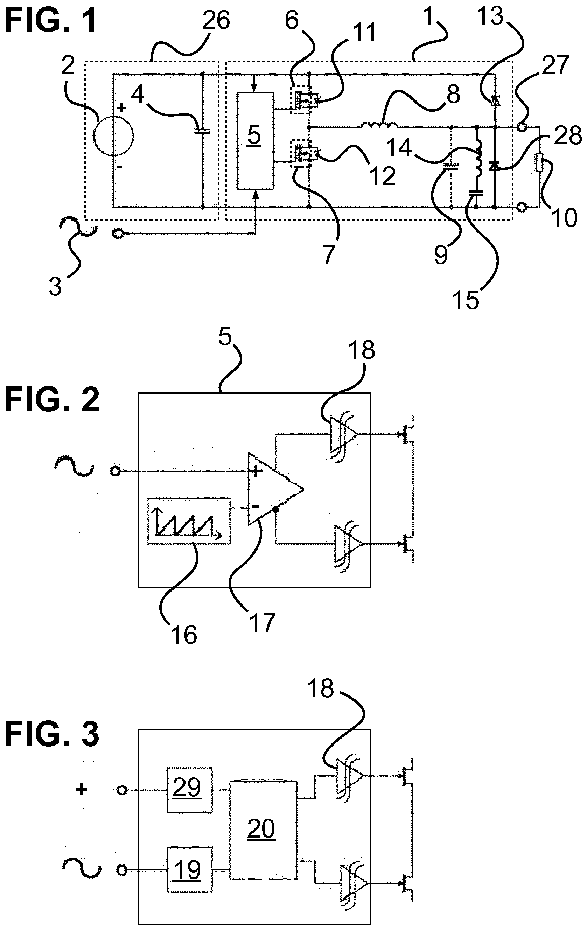

Der Modulator 1 weist eine Steuerung 5 auf. Alternative Ausführungsformen der Steuerung sind in den Figuren 2 und 3 gezeigt. In beiden Fällen wird der Steuerung 5 das Führungssignal 3 zugeführt. Bei der analogen Steuerung nach Fig. 2 ist das Führungssignal 3 auf den positiven Eingang eines Komparators 17 geschaltet. Der negative Eingang ist mit einem Sägezahn-Generator 16 verbunden. Der Komparator 17 weist einen herkömmlichen Ausgang und einen invertierten Ausgang auf. Beide Ausgänge sind mit je einer galvanisch getrennten Treiberschaltung 18 für die elektronischen Schaltelemente 6 und 7 verbunden, die die erforderlichen Signale zur optimalen Ein/Aus-Steuerung der elektronischen Schaltelemente 6 und 7 liefern. Der Komparator 17 vergleicht die Spannungsamplitude des Führungssignals 3 mit der Amplitude des Signals des Sägezahn-Generators 16 und schaltet entsprechend dem Ergebnis entweder auf den einen oder den anderen Ausgang durch. Durch den invertierten Ausgang ist sichergestellt, dass nur immer einer der Ausgänge bestromt ist. Die Schaltfrequenz der elektronischen Schaltelemente 6 und 7 entspricht der des Sägezahngenerators 16.

Die digitale Steuerung aus Fig. 3 weist einen ersten Analog-Digital-Wandler 19 (Analog-Digital-Converter, kurz ADC) auf, dem das Führungssignal 3 zugeführt wird und von dem digitale Datenpackete erzeugt und an den digitalen Controller 20 übergeben werden. Ist der ADC 19 als einziger ADC vorgesehen, schaltet der digitale Controller 20 die FETs 6 und 7 auf der Grundlage der Beziehung

$$U_a = U_{in} * v_t \, ,$$

wobei $U_a$ die an den Klemmen 27 anliegende Ausgangsspannung, $U_{in}$ die Eingangsspannung des Führungssignals 3 und $v_t$ das Tastverhältnis ist. Das Tastverhältnuis ist die relative Einschaltdauer der elektronischen Schaltelement 6 und 7. Das Tastverhältnis und damit die Schaltfrequenz der elektronischen Schaltelemente 6 und 7 wird durch einen Frequenzgenerator im Controller 20 vorgegeben. Die beiden Schalter werden wie bei der analogen Steuerung invertiert angesteuert.

In dem besonders vorteilhaften Ausführungsbeispiel nach Fig. 3 ist noch ein weiterer ADC 29 vorgesehen, der mit der Gleichspannungsquelle 2 (siehe den gestrichelten Pfeil in Fig. 1) und ebenfalls mit dem digitalen Controller 20 verbunden ist. Die digitalisierte Spannung der geregelten Gleichspannungsquelle wird als Variable Uo in die Berechnung des digitalen Controllers 20 mit aufgenommen. Die entsprechend geänderte Formel lautet dann

$$U_a = U_{in} * U_0 * v_t \ .$$

Auf diese Weise ist folglich auch die Kompensation der Restwelligkeit einer nicht optimal geregelten Gleichspannungsquelle über eine ungeregelte Steuerung möglich, ohne dass die Nachteile einer Regelschleife in Kauf genommen werden müssten. Da sich hierdurch Kosten bei der geregelten Gleichspannungsquelle 2 einsparen lassen, ist diese Lösung sehr kostengünstig, mit wenigen Verlusten behaftet und arbeitet trotzdem sehr genau.

Von der Steuerung 5 werden alternierend die beiden elektronischen Schaltelemente 6 und 7 angesteuert, die insbesondere als FETs ausgeführt sind. Moderne elektronische Bauteile dieser Art besitzen im eingeschalteten Zustand einen Durchgangswiderstand im einstelligen Milliohm-Bereich. Bei hohen Strömen lassen sich auch mehrere dieser FETs parallel schalten, so dass der Durchgangswiderstand auf diese Weise noch weiter gesenkt werden kann.

Die beiden elektronischen Schaltelemente 6 und 7 werden gegenphasig angesteuert. Im Betrieb ist immer eines der beiden elektronischen Schaltelemente leitend. Tastverhältnis 1 besteht, wenn sich das erste elektronische Schaltelement 6 dauernd im eingeschalteten-Zustand befindet. Tastverhältnis 0 besteht dagegen, wenn sich das erste elektronische Schaltelement 6 ständig im ausgeschalteten Zustand befindet.

Diese Schaltungsanordnung ist nicht als analoge Endstufe ausgeführt, bei der die elektronischen Schaltelement im Linearbetrieb, ähnlich einem gesteuerten Widerstand betrieben werden. In der hier gezeigten Schaltung ist immer eines der beiden elektronischen Schaltelemente 6 und 7 voll leitend, also derart angesteuert, dass es seinen minimalen Einschaltwiderstand erreicht, während das andere elektronische Schaltelement in diesem Moment hochohmig, also stromlos ist.

Jeweils parallel zu den beiden elektronischen Schaltelementen sind die beiden Freilaufdioden 11 und 12 geschaltet. Diese Freilaufdioden besitzen während des normalen Betriebs keine Funktion, werden aber beispielsweise bei einem durch Überstrom veranlassten plötzlichen Abschalten der elektronischen Schaltelemente zur Ableitung der in der Spule 8 gespeicherten Energie benötigt. Die schaltungstechnische Realisierung für so ein plötzliches Abschalten ist in dem gezeigten Ausführungsbeispiel aus Gründen der Vereinfachung nicht detailliert dargestellt. In üblicher Weise erfolgt eine Schutzabschaltung aber über direkten Eingriff in die Treiber der FETs 6 und 7, in dem gezeigten Ausführungsbeispiel also in die Treiberschaltungen 18 mit galvanischer Trennung.

Die Spule 8 bildet zusammen mit den beiden elektronischen Schaltelementen 6 und 7 den Kern des Modulators 1. Um eine möglichst geringe Phasenverschiebung zwischen der Spannung des der Steuerung 5 zugeführten Führungssignals und der an den Klemmen 27 des Modulators anliegenden Ausgangsspannung zu erreichen, ist die Spule 8 als möglichst kleine Induktivität ausgeführt. Andererseits muss aber eine Mindestgröße der Induktivität gegeben sein, um die notwendige Filterwirkung gewährleisten zu können. Im hier gezeigten Ausführungsbeispiel wird eine Spule mit einer Induktivität von 3 µH verwendet.

Der Glättungskondensator 9 hat die Aufgabe den durch die Schaltfrequenz der Steuerung 5 erzeugten Ripple in der an den Klemmen 27 anliegenden Ausgangsspannung, dem Modulationssignal, zu reduzieren. Der Glättungskondensator 9 soll trotzdem möglichst klein gehalten sein, um die Blindströme während der Modulation möglichst gering halten zu können. In dem gezeigten Ausführungsbeispiel wird ein Keramik-Kondensator mit einer Kapazität von 6 µF verwendet.

Der Saugkreis aus der Resonanzspule 14 und dem Resonanzkondensator 15 ist so abgestimmt, dass seine Resonanzfrequenz der Schaltfrequenz der Steuerung 5 entspricht. Der Saugkreis hat bei der Resonanzfrequenz einen sehr geringen Widerstand und schließt auf diese Weise die Anteile der Schaltfrequenz gegen den Minuspol der Gleichspannungsquelle kurz. Auf diese Weise können Resonanzanteile eliminiert werden. Der Saugkreis wirkt somit als optimaler Filter. Auf diese Weise kann der das System mit Blindstrom belastende Glättungskondensator 9 sehr klein dimensioniert werden. In dem gezeigten Ausführungsbeispiel wird für den Resonanzkondensator 15 eine Kapazität von 2 µF und für die Resonanzspule 14 eine Induktivität von 0,14 µH verwendet.

Der dargestellte Glättungskondensator 9 stellt den aufsummierten Wert der in der Schaltung verwendeten effektiven Kondensatoren dar. Unter effektiven Kondensatoren wird hier verstanden, dass diese auch bei hohen Strömen wirksam sind und damit einen entsprechend niedrigen seriellen Ersatzwiderstand haben. Um bei dem hier gezeigten Modulator 1 die Schaltung nicht mit Blindströmen während der Modulation zu stark zu belasten, muss die Summe der im Spannungspfad verwendeten Kondensatoren, die alle als Glättungskondensatoren wirken, möglichst klein sein. Die wenigen noch verbleibenden Kondensatoren sind hohen Strombelastungen ausgesetzt und sollten daher zweckmässigerweise als Keramikkondensatoren ausgeführt werden. Diese Kondensatoren im Kapazitätsbereich von 0,1 bis etwa 1 μF besitzen einen sehr niedrigen seriellen Ersatzwiderstand und sind damit trotz kleiner Kapazität in ihrer Aufgabe als Filterkondensatoren sehr wirkungsvoll.

Die Spannungsbegrenzungsdioden 13 und 28 nehmen während des Normalbetriebs der Schaltung keine Funktion wahr. Im Falle eines plötzlichen Lastabwurfs jedoch können Sie eine Schädigung der Last 10 durch auftretende Überspannungen verhindern. Über die Spannungsbegrenzungsdiode 13 kann in diesem Fall die in der Spule 9 gespeicherte Energie in den Kondensator 4 zurückgeführt werden. Um diesen Schutz auch dann gewährleisten zu können, wenn der plötzliche Lastabwurf zum Zeitpunkt der Stromrückspeisung (negative Flanke des Spannungsverlaufs) erfolgt, ist die zweite Spannungsbegrenzungsdiode 28 vorgesehen, die die Energie zum Minuspol der Gleichspannungsquelle ableitet.

Für einen ähnlichen Fall sind die erste 11 und die zweite Freilaufdiode 12 vorgesehen, die parallel zu dem ersten 6 bzw. zu dem zweiten elektronische Schaltelement 7 geschaltet sind. Sollte plötzlich die Schaltstufe mit der Steuerung 5 und den beiden elektronischen Schaltelementen 6 und 7 abgeschaltet werden, wird die Energie aus der Spule 8 über diese Freilaufdioden 11 und 12 abgeleitet. Diese Aufgabe könnte gegebenenfalls auch durch parasitäre Dioden übernommen werden, die in den elektronischen Schaltelementen 6 und 7 direkt verbaut sind. In diesem Fall könnten die separaten Freilaufdioden 11 und 12 entfallen.

Amplitudenmodulierte Hochfrequenzsignale werden üblicherweise mit Leistungsverstärkern erzeugt, die mit einer konstanten Gleichspannungsquelle versorgt werden. Die Leistungsverstärker werden dabei über ein zusammengesetztes Steuersignal amplitudenmoduliert, welches Trägerfrequenz und Amplitudenmodulation vereint. Solche Leistungsverstärker mit großem Dynamikumfang, die im Hochfrequenzbereich eingesetzt werden können, sind in der Regel als Linearverstärker ausgebildet. Besonders im Teillastbereich, also im mittleren Bereich der Modulationsamplitude, haben diese Verstärker jedoch einen schlechten Wirkungsgrad.

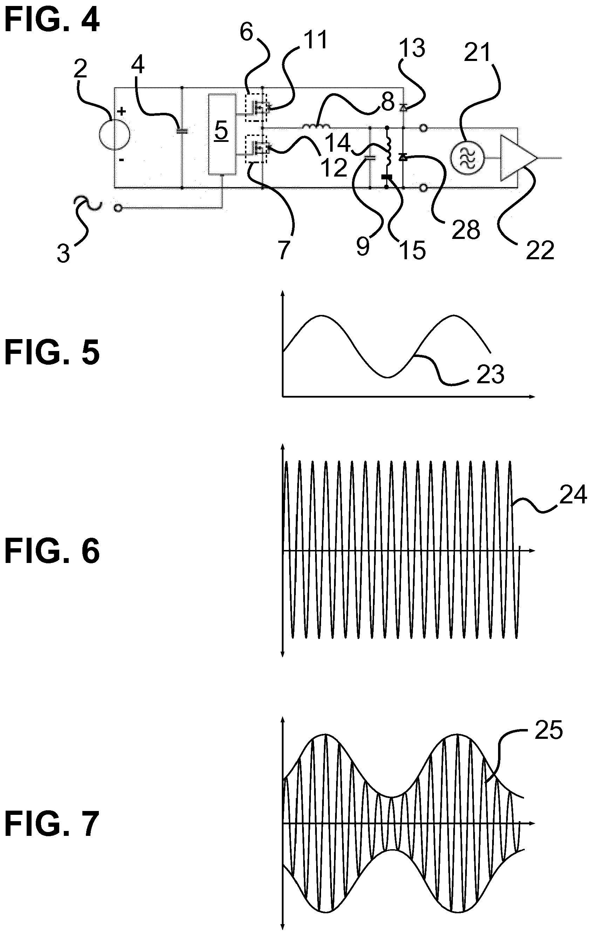

In Fig. 4 ist eine Anwendungsmöglichkeit der Erfindung gezeigt, mit der ein solches amplitudenmoduliertes Hochfrequenzsignal mit hohem Wirkungsgrad erzeugt werden kann. Dabei wird die in Fig. 1 gezeigte Last 10 durch den Hochfrequenzverstärker 22 gebildet. Eine entsprechende Schaltung kann beispielsweise als Stromversorgung eines Plasmagenerators verwendet werden. Speziell in der Zündphase des Plasmas werden für diese Anwendungen hoch dynamische Hochfrequenzgeneratorsysteme gefordert, um zu verhindern, dass bei Fehlanpassung und rücklaufender Sendeleistung die Endstufe zerstört wird.

Der Hochfrequenzverstärker 22 wird mit dem in Fig. 5 gezeigten geglätteten Modulationssignal 23 als Versorgungsspannung gespeist, die an den Klemmen 27 des Modulators 1 anliegt. Gleichzeitig wird dem Hochfrequenzverstärker 22 das in Fig. 6 dargestellte Hochfrequenzsignal 24 eines Hochfrequenzoszillators 21 als Trägersignal zugeführt. Aus der Versorgungsspannung und dem Trägersignal entsteht am Ausgang des Hochfrequenzverstärkers 22 dann das in Fig. 7 gezeigte moduliert Hochfrequenzsignal 25, bei dem es sich um ein amplitudenverstärktes Signal handelt, wobei auf das hochfrequente Trägersignal 24 des Hochfrequenzoszillators 21 das Modulationssignal 23 aufmoduliert wurde.

Bei der Signaldarstellung in den Figuren 5 und 7 wurde davon ausgegangen, dass es sich bei dem Modulationssignal 23 um ein sinusförmiges Signal handelt. Selbstverständlich ist aber - je nach Anwendung - auch jede andere Signalform, sogar mit statischen Bereichen, möglich. Bei dem Hochfrequenzsignal 24 handelt es sich dagegen immer um ein sinusförmiges Signal.

Bei dem Ausführungsbeispiel nach Fig. 1 wird der Steuerung 5 des Modulators 1 beispielsweise ein sinusförmiges Führungssignal 3 mit sich schnell ändernder Frequenz zugeführt. Die Modulationsfrequenz des Führungssignals 3 beträgt bei diesem Beispiel bis zu 10 kHz. Dieses Führungssignal weist z. B. eine Spannungsamplitude von 5 V auf.

Der Modulator 1 ist mit einer statischen Gleichspannungsquelle 2 verbunden, die eine Spannung von 50 V und einen Maximalstrom von 100 A liefert. Die Gleichspannungsquelle 2 kann folglich mit einer maximalen Leistung von 5 kW belastet werden.

Die Steuerung 5 schaltet die beiden FETs 6 und 7 in der bereits oben erläuterten Weise mit einer Schaltfrequenz von 300 kHz. Bei einem Modulationshub von 100% ergibt sich daraus ein Modulationssignal, dessen Frequenz der Frequenz des Führungssignals 3 entspricht, das aber eine Spannung mit einer Amplitude von 50 V bei einer maximalen Leistung von 5kW aufweist. Das modulierte Gleichspannungssignal weist einen gewissen Ripple auf, der der Schaltfrequenz von 300 kHz entspricht. Es entsteht folglich eine Sinusspannung mit einer höherfrequenten Oberschwingung. Dieser Ripple lässt sich durch entsprechende Auslegung der Kapazitäten so weit glätten, dass bei dem an den Klemmen 27 anliegenden Modulationssignal die Oberschwingung nur noch eine leichte Welligkeit aufweist. Diese Oberschwingung wird um so geringer je mehr sich die Schaltfrequenz von der Modulationsfrequenz unterscheidet.

Durch den besonderen Aufbau der Schaltung unterscheidet sich die Phase des Modulationssignals nur sehr geringfügig von der Phase des Führungssignals 3. Durch die verwendeten kleinen Kapazitäten und Induktivitäten und die exakte Abstimmung des Saugkreises mit dem Resonanzkondensator 15 und der Resonanzspule 14 werden während der Modulation nur sehr geringe Blindströme generiert und die Modulation findet mit einem sehr hohen Wirkungsgrad statt. Durch die erfindungsgemäße Schaltung entsteht folglich aus dem zugeführten Führungssignal 3 ein Modulationssignal mit gleicher Frequenz und sehr geringen Phasenverschiebung, aber mit größerer Amplitude und höherer Leistung.

Das in Fig. 1 gezeigte Ausführungsbeispiel lässt sich mit geeigneten Bauteilen auch so auslegen, dass ein Führungssignal bis in den 100 kHz-Bereich und höher verarbeitet werden kann. Bei Einsatz einer entsprechenden statischen Gleichspannungsquelle werden Leistungen bis in den mittleren zweistelligen kW-Bereich möglich. Die erfindungsgemäße Schaltung kommt vollkommen ohne geschlossenen Regelkreis aus, da sie sich fast wie ein ideales System verhält. Zu diesem Verhalten tragen insbesondere die modernen elektronischen Schaltelemente 6 und 7 bei, die einen extrem niedrigen Einschaltwiderstand von nur wenigen Milliohm aufweisen. Bei Anforderungen an höhere Ströme sind diese Bauelemente relativ einfach parallel zu schalten und der Einschaltwiderstand lässt sich damit weiter minimieren. Somit müssen keine durch Laständerung hervorgerufenen internen Spannungsabfälle ausgeregelt werden, weil kaum interne Widerstände vorhanden sind, die für einen entsprechenden Spannungsabfall verantwortlich wären. Die Funktion der Ausgangsspannung ist damit einfach zu definieren und kann mit einer analogen oder digitalen Steuerung ohne geschlossenen Regelkreis nachgebildet werden.

Ein sehr hoher Systemwirkungsgrad der in Fig. 4 gezeigten Anordnung kann dadurch erreicht werden, dass der Hochfrequenzverstärker 22 mit dem Hochfrequenzoszillator 21 immer voll ausgesteuert wird. Der analoge Hochfrequenzverstärker 22 hat bei Vollaussteuerung seinen höchsten Wirkungsgrad. Die Amplituden- bzw. Leistungsmodulation des Systems erfolgt nur mit der Änderung des Modulationssignals 23, also der Versorgungsspannung des Hochfrequenzverstärkers 22. Da auch der Modulator 1, der das Modulationssignal 23 und damit die Versorgungsspannung für den Hochfrequenzverstärker 22 generiert, einen sehr hohen Wirkungsgrad, hohe Dynamik und gute Linearität aufweist, ergibt sich der sehr hohe Systemwirkungsgrad.

Bezugszeichenliste:

1    Modulator
2    statische Gleichspannungsquelle
3    Führungssignal
4    Kondensator
5    Steuerung
6    erstes elektronisches Schaltelement
7    zweites elektronisches Schaltelement
8    Spule
9    Glättungskondensator
10   Last

11   erste Freilaufdiode
12   zweite Freilaufdiode
13   erste Spannungsbegrenzungsdiode
14   Resonanzspule
15   Resonanzkondensator
16   Sägezahn-Generator
17   Komparator
18   Treiberschaltung mit galvanischer Trennung
19   Analog-Digital-Konverter
20   Digitaler Controller
21   Hochfrequenzoszillator
22   Hochfrequenzverstärker
23   Modulationssignal als Versorgungsspannung für den Hochfrequenzverstärker
24   Hochfrequenzsignal des Hochfrequenzoszillators als Trägersignal
25   moduliertes Hochfrequenzsignal
26   Stromversorgung
27   Klemmen
28   zweite Spannungsbegrenzungsdiode
29   weiterer Analog-Digital-Konverter

**Patentansprüche**

1.  Spannungsquelle für modulierte Gleichspannungen zum Verstärken der Leistung eines Führungssignals (3), wobei die Spannungsquelle eine statische Gleichspannungsquelle (2) mit wenigstens einem parallelen Kondensator (4) aufweist, wobei die Ausgangsspannung der statischen Gleichspannungsquelle (2) geregelt ist, wobei die Spannungsquelle eine ungeregelte Steuerung, ein erstes, durch die ungeregelte Steuerung (5) ein- oder ausschaltbares, elektronisches Schaltelement (6), ein zweites, durch die ungeregelte Steuerung (5) ein- oder ausschaltbares, elektronisches Schaltelement (7), eine in Reihe mit dem ersten elektronischen Schaltelement (6) geschaltete Spule (8), einen in Reihe mit der Spule (8) geschalteten Glättungskondensator (9) und eine parallel zu dem Glättungskondensator (9) geschaltete Last (10) aufweist, wobei das zweite elektronische Schaltelement mit dem ersten elektronischen Schaltelement (6) eine Halbbrücke bildet.

2.  Spannungsquelle nach Anspruch 1, **dadurch gekennzeichnet, dass** sowohl das erste elektronische Schaltelement (6) als auch das zweite elektronisches Schaltelement (7) jeweils als Feldeffekttransistor ausgebildet ist.

3.  Spannungsquelle nach einem der Ansprüche 1 bis 2, **dadurch gekennzeichnet, dass** das erste (6) und das zweite elektronische Schaltelement (7) gegenphasig geschaltet sind.

4.  Spannungsquelle nach einem der Ansprüche 1 bis 3, **dadurch gekennzeichnet, dass** die ungeregelte Steuerung (5) als digitale Steuerung (18, 19, 20) aufgebaut ist, die wenigstens einen Analog-Digital-Wandler (19) und einen digitalen Controller (20) aufweist.

5. Spannungsquelle nach Anspruch 4, **dadurch gekennzeichnet, dass** die digitale Steuerung (5) einem weiteren Analog-Digital-Wandler (29) aufweist, der mit der geregelten Gleichspannungsquelle (2) und mit dem digitalen Controller (20) verbunden ist.

6. Spannungsquelle nach einem der Ansprüche 1 bis 3, **dadurch gekennzeichnet, dass** die ungeregelte Steuerung (5) als analoge Steuerung (16, 17, 18) mit einem Komparator (17) aufgebaut ist.

7. Spannungsquelle nach einem der Ansprüche 1 bis 6, **dadurch gekennzeichnet, dass** parallel zu dem ersten (6) und dem zweiten elektronischen Schaltelement (7) jeweils eine Freilaufdiode (11, 12) geschaltet ist.

8. Spannungsquelle nach einem der Ansprüche 1 bis 7, **dadurch gekennzeichnet, dass** eine erste Spannungsbegrenzungsdiode (13) in Reihe zu der Spule (8) und parallel zu dem ersten elektronischen Schaltelement (6) geschaltet ist oder dass die erste Spannungsbegrenzungsdiode (13) und eine zweite Spannungsbegrenzungsdiode (28) parallel zu dem zweiten elektronischen Schaltelement (7) geschaltet sind.

9. Spannungsquelle nach einem der Ansprüche 1 bis 8, **dadurch gekennzeichnet, dass** die ungeregelte Steuerung (5) das erste (6) und das zweite elektronische Schaltelement (7) mit einer Frequenz größer 200 kHz schaltet.

10. Spannungsquelle nach einem der Ansprüche 1 bis 9, **dadurch gekennzeichnet, dass** die modulierte Gleichspannung eine Frequenz bis zu 200 kHz aufweist.

11. Spannungsquelle nach einem der Ansprüche 1 bis 10, **dadurch gekennzeichnet, dass** ein Saugkreis mit einer Resonanzspule (14) und einem Resonanzkondensator (15) vorgesehen ist, wobei der Saugkreis parallel zu dem Glättungskondensator (9) angeordnet ist

12. Spannungsquelle nach einem der Ansprüche 1 bis 11, **dadurch gekennzeichnet, dass** die Spule (8) und der Glättungskondensator (9) auf eine Resonanzfrequenz abgestimmt sind, die zwischen einem Drittel und einem Fünfzehntel der Frequenz beträgt, mit der das erste (6) und das zweite elektronische Schaltelement (7) geschaltet werden.

13. Spannungsquelle nach einem der Ansprüche 1 bis 12, **dadurch gekennzeichnet, dass** als Last (10) ein Hochfrequenzverstärker (22) vorgesehen ist, der zusätzlich mit einem Hochfrequenzsignal (24) aus einem Hochfrequenzoszillator (21) gespeist wird.

14. Spannungsquelle nach einem der Ansprüche 1 bis 13, **dadurch gekennzeichnet, dass** die Spannungsquelle als Schaltnetzteil mit einer Ausgangsleistung von mehr als ein Kilowatt ausgebildet ist.

**Claims**

1. A voltage source for modulated DC voltages for amplifying the power of a reference signal (3), wherein the voltage source has a static DC voltage source (2) with at least one parallel capacitor (4), wherein the output voltage of the static DC voltage source (2) is regulated, the voltage source having an unregulated controller; a first electronic switching element (6) which can be switched on or off by the unregulated controller (5); a second electronic switching element (7), which can be switched on or off by the unregulated controller (5); a coil (8) connected in series with the first electronic switching element (6);a smoothing capacitor (9) connected in series with the coil (8), and a load (10) connected in parallel with the smoothing capacitor (9), the second electronic switching element forming a half-bridge with the first electronic switching element (6).

2. Voltage source according toClaim 1, **characterized in that** both the first electronic switching element (6) and the second electronic switching element (7) are designed as field effect transistors.

3. Voltage source according toeither of Claims 1 to 2, **characterized in that** the first (6) and the second electronic switching element (7) are connected in antiphase.

4. Voltage source according toany one of Claims 1 to 3, **characterized in that** the unregulated controller (5) is designed as a digital controller (18, 19, 20) comprising at least one analogue-to-digital converter (19) and a digital controller (20).

5. Voltage source according toClaim 4, **characterized in that** the digital controller (5) has an additional analogue-to-digital converter (29) that is connected to the regulated DC voltage source (2) and to the digital controller (20).

6. Voltage source according toany one of Claims 1 to 3, **characterized in that** the unregulated controller (5) is designed as an analogue controller (16, 17, 18) with a comparator (17).

**7.** Voltage source according toany one of Claims 1 to 6, **characterized in that** a freewheeling diode (11, 12) is connected in parallel with each of the first (6) and the second electronic switching element (7).

**8.** Voltage source according toany one of Claims 1 to 7, **characterized in that** a first voltage-limiting diode (13) is connected in series with the coil (8) and in parallel with the first electronic switching element (6), or **in that** the first voltage-limiting diode (13) and a second voltage-limiting diode (28) are connected in parallel with the second electronic switching element (7).

**9.** Voltage source according toany one of Claims 1 to 8, **characterized in that** the unregulated controller (5) switches the first (6) and the second electronic switching element (7) with a frequency greater than 200 kHz.

**10.** Voltage source according toany one of Claims 1 to 9, **characterized in that** the modulated DC voltage has a frequency of up to 200 kHz.

**11.** Voltage source according toany one of Claims 1 to 10, **characterized in that** a suction circuit with a resonance coil (14) and a resonance capacitor(15) is provided, the suction circuit being arranged in parallel with the smoothing capacitor (9).

**12.** Voltage source according toany one of Claims 1 to 11, **characterized in that** the coil (8) and the smoothing capacitor (9) are tuned to a resonance frequency that is between one third and one fifteenth of the frequency with which the first (6) and the second electronic switching element (7) are switched.

**13.** Voltage source according toany one of Claims 1 to 12, **characterized in that** a high-frequency amplifier (22), which is additionally supplied with a high-frequency signal (24) from a high-frequency oscillator (21), is provided as a load (10).

**14.** Voltage source according toany one of Claims 1 to 13, **characterized in that** the voltage source is designed as a switched-mode power supply with an output power of more than one kilowatt.

**Revendications**

**1.** Source de tension pour des tensions continues modulées pour amplifier la puissance d'un signal de guidage (3), dans laquelle la source de tension présente une source de tension continue statique (2) avec au moins un condensateur parallèle (4), dans laquelle la tension de sortie de la source de tension continue statique (2) est régulée, dans laquelle la source de tension présente une commande non régulée, un premier élément de commutation électronique (6) pouvant être mis sous tension ou hors tension par la commande non régulée (5), un deuxième élément de commutation électronique (7) pouvant être mis sous tension ou hors tension par la commande non régulée (5), une bobine (8) commutée en série avec le premier élément de commutation électronique (6), un condensateur de filtrage (9) commuté en série avec la bobine (8) et une charge (10) commutée parallèlement au condensateur de filtrage (9), dans laquelle le deuxième élément de commutation électronique forme un demi-pont avec le premier élément de commutation électronique (6).

**2.** Source de tension selon la revendication 1, **caractérisée en ce que** non seulement le premier élément de commutation électronique (6) mais aussi le deuxième élément de commutation électronique (7) est réalisé à chaque fois sous forme de transistor à effet de champ.

**3.** Source de tension selon l'une des revendications 1 à 2, **caractérisée en ce que** le premier (6) et le deuxième élément de commutation électronique (7) sont commutés en opposition de phase.

**4.** Source de tension selon l'une des revendications 1 à 3, **caractérisée en ce que** la commande non régulée (5) est conçue comme une commande numérique (18, 19, 20) qui présente au moins un convertisseur analogique - numérique (19) et un dispositif de contrôle numérique (20).

**5.** Source de tension selon la revendication 4, **caractérisée en ce que** la commande numérique (5) présente un autre convertisseur analogique - numérique (29) qui est relié à la source de tension continue régulée (2) et au dispositif de contrôle numérique (20).

**6.** Source de tension selon l'une des revendications 1 à 3, **caractérisée en ce que** la commande non régulée (5) est conçue comme une commande analogique (16, 17, 18) avec un comparateur (17).

**7.** Source de tension selon l'une des revendications 1 à 6, **caractérisée en ce qu'**est commutée à chaque fois une diode de roue libre (11, 12) parallèlement au premier (6) et au deuxième élément de commutation électronique (7).

**8.** Source de tension selon l'une des revendications 1 à 7, **caractérisée en ce qu'**une première diode limitant la tension (13) est commutée en série à la bobine (8) et parallèlement au premier élément de commutation électronique (6) ou **en ce que** la première diode limitant la tension (13) et une deuxième diode limitant la tension (28) sont commutées en parallèle au deuxième élément de commutation électronique (7).

9. Source de tension selon l'une des revendications 1 à 8, **caractérisée en ce que** la commande non régulée (5) commute le premier (6) et le deuxième élément de commutation électronique (7) à une fréquence supérieure à 200 kHz.

10. Source de tension selon l'une des revendications 1 à 9, **caractérisée en ce que** la tension continue modulée présente une fréquence allant jusqu'à 200 kHz.

11. Source de tension selon l'une des revendications 1 à 10, **caractérisée en ce qu'**un circuit d'absorption avec une bobine de résonance (14) et un condensateur de résonance (15) est prévu, le circuit d'absorption étant disposé parallèlement au condensateur de filtrage (9).

12. Source de tension selon l'une des revendications 1 à 11, **caractérisée en ce que** la bobine (8) et le condensateur de filtrage (9) sont accordés à une fréquence de résonance, qui s'élève entre un tiers et un quinzième de la fréquence, à laquelle sont commutés le premier (6) et le deuxième élément de commutation électronique (7).

13. Source de tension selon l'une des revendications 1 à 12, **caractérisée en ce qu'**est prévu comme charge (10) un amplificateur haute fréquence (22) qui est, en outre, alimenté par un signal haute fréquence (24) provenant d'un oscillateur haute fréquence (21).

14. Source de tension selon l'une des revendications 1 à 13, **caractérisée en ce que** la source de tension est conçue comme un convertisseur continu-continu avec une puissance de sortie de plus d'un kilowatt.

**FIG. 1**

**FIG. 2**

**FIG. 3**

# FIG. 4

# FIG. 5

# FIG. 6

# FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2004110282 A

- US 20140285258 A1